# EUROPÄISCHE PATENTANMELDUNG

(11) **EP 2 336 385 A1**
(43) Veröffentlichungstag der Anmeldung: **22.06.2011**
(21) Anmeldenummer: 10193995.7
(22) Anmeldetag: 07.12.2010
(51) Int. Cl.: C23C 14/06, C23C 30/00, H01F 10/14, H01F 10/16

(54) **Metastabiles, nanostabilisiertes Material und Verfahren zu dessen Herstellung**

(30) Priorität: 09.12.2009 DE 102009044838
(71) Anmelder: Karlsruher Institut für Technologie, 76131 Karlsruhe (DE)
(72) Erfinder: Klever, Christian, 76137, Karlsruhe (DE); Leiste, Harald, 76356, Weingarten (DE); Seemann, Klaus, 76448, Durmersheim (DE); Stüber, Michael, 76829, Landau (DE); Ulrich, Sven, 76297, Stutensee/Blankenloch (DE)
(74) Vertreter: Fitzner, Uwe

(57) **Zusammenfassung**

Die vorliegende Erfindung betrifft ein metastabiles, nanostabilisiertes Material, aufgebaut aus mehreren Lagen (A,B), beide in kubisch flächenzentrierter Gitterstruktur, wobei die Lage (A) die allgemeine Formel (R,N) und die Lage (B) die allgemeine Formel (R,aÜM)N aufweist, wobei
R
Refraktäres Element, ausgewählt aus der Gruppe bestehend aus Ti, Ta, Hf, V, Nb, Zr, Cr und Mischungen davon,
ÜM
Übergangsmetalle, aus gewählt aus der Gruppe bestehend aus Fe, Co und Mischungen davon,
N
Stickstoff,

a = 1, 2, wobei a für die Anzahl unterschiedlicher ÜM steht, Herstellungsverfahren und Verwendung.

## Beschreibung

Die vorliegende Erfindung betrifft ein Verfahren zur Herstellung eines metastabilen, nanostabilisierten Materials. Ferner betrifft sie das Material als solches sowie dessen Herstellung.

Es gibt für einzelne Funktionalitäten wie Verschleißfestigkeit und Ferromagnetismus seit Jahren geeignete Materialien. So ist TiN seit mehr als 20 Jahren als Verschleißschutzschicht verfügbar. Für Verschleißschutzanwendungen wurde TiN durch viele Materialien ersetzt, wie z.B. durch TiCN, TiAIN, TiB₂, TiAION, Al₂O₃ und ähnliche Materialien. Auch Materialkonzepte, z.B. metastabile Materialien wie TiAIN und Schichtkonzepte, z.B. Viellagen-Schichten, sind auf dem Gebiet des Verschleißschutzes verwendet worden. Im Bereich der ferromagnetischen Dünnschichten für Hochfrequenzanwendungen, d.h. Anwendungen mit hohen Permeabilitäten bei hohen Grenzfrequenzen (in GHz-Bereich), wird meist Fe, Co, Ni für die Einlagenschichten angewendet. Oft erfolgt der Einsatz gemeinsam mit weiteren Elementen, z.B. B, Si, Zr, Ta, Hf, Ti, O, N und ähnliche Elemente.

Aus "A. Kirsten, C. Pietzsch, H. Oettel, (Thin Solid Films 288, 1996) 198 - 201, Mössbauer Investigations of (Ti,Fe)N hard coatings" ist die Kombination von Ti, Fe (N) für eine geringe Konzentration von 13 at% Fe in der Struktur eines kubisch flächenzentrierten Gitters bekannt (FCC-Gitter). Nach diesem Stand der Technik entsteht eine (Ti,Fe)N-Verbindung demgemäß mit niedrigem Fe-Gehalt. Mittels Magnetkathodenzerstäubung kann eine gewisse Löslichkeit realisiert werden und es entsteht ein metastabiler Mischkristall. Es hatte sich gezeigt, dass bei Viellagenschichten mit höherer Anzahl von Lagen der Verbund der Lagen die Struktur der Einzellagenmaterialien aufweist. So wächst die Ti-N-Lage in der kubisch flächenzentrierten Struktur und die FeCo-Lage in der kubisch raumzentrierten Gitterstruktur.

Nachteil dieses Materials ist, dass die (bisherigen) ferromagnetischen Hochfrequenzeigenschaften nicht ausreichen. Ebenso sind die mechanischen Eigenschaften noch nicht für alle Einsatzgebiete zufriedenstellend.

Die vorliegende Erfindung hat sich demgemäß die Aufgabe gestellt, ein neues, metastabiles, nanostabilisiertes Material zur Verfügung zu stellen, dass sowohl ausgezeichnete mechanische als auch ferromagnetische Eigenschaften besitzt. Ferner ist Aufgabe der Erfindung, ein entsprechendes Herstellungsverfahren zu entwickeln.

Das Material soll sowohl das Problem des Verschleißschutzes, als auch, gleichzeitig, der magnetischen Eigenschaften lösen.

Der Begriff "metastabil" bedeutet im Rahmen der vorliegende Erfindung:
Ein Material, das sich nicht im thermodynamischen Gleichgewicht befindet und somit nicht in Gleichgewichtsphasendiagrammen beschrieben ist. Metastabil bezieht sich somit auf die Zusammensetzung und die Kristalistruktur. Ein solches metastabiles System besitzt somit eine kinetische Hemmung, die den Übergang zum thermodynamisch stabilen Zustand behindert. Der Übergang in den thermodynamischen Zustand erfolgt durch Energieeintrag, wodurch eine vorhandene Energiebarriere überwunden werden kann.
Der Begriff "nanostabilisiert" bedeutet im Rahmen der vorliegende Erfindung:
Ein Material wird als nanostabilisiert bezeichnet, wenn durch epitaktische Beeinflussung eines vorgegebenen Substrates das Material entweder bereits bei niederen Temperaturen kristallin oder orientiert, oder in einer untypischen Kristallstruktur oder untypischen Kristallorientierung aufwächst.
Der Begriff "refraktäres Element" bedeutet im Rahmen der vorliegende Erfindung ein Element der 4., 5. und 6., Nebengruppe: Ti, Zr, Hf, V, Nb, Ta, Cr.
Der Begriff "Verschleißbereich" bedeutet im Rahmen der vorliegende Erfindung:
Von Verschleiß wird bei mechanisch und/oder chemisch bedingten Oberflächenveränderungen gesprochen. Insbesondere ist dabei meist eine Volumenänderung (Abtrag) gemeint, Verschleißbereich kann sich auf den Ort aber auch andere Größen wie Temperatur, Luftfeuchte oder weitere Einflußgrößen beziehen.
Der Begriff "Target" bedeutet im Rahmen der vorliegende Erfindung:
Unter dem Begriff Target wird in der Dünnschichttechnologie die Festkörpermaterialquelle verstanden. Bei PVD-Verfahren wird eine Schicht dadurch erzeugt, dass neutrale oder geladene Teilchen (oft Ar-lonen) auf eine Oberfläche (z.B. Material Platte aus Titan) beschleunigt werden und von dieser Materialplatte dann Atome, Ionen oder Cluster abtragen. Diese freigesetzten Atome oder Ionen fliegen in der Regel ohne weitere Stöße (gasdruckabhängig) in den Raum und kondensieren auf allen Oberflächen, wo sie eine Schicht ausbilden. Bei vorhandenem Reaktivgas (z. B. N₂) kann dieses aufgenommen werden und zur Bildung von Verbindungen (z.B. TiN) beitragen.
Im Rahmen der vorliegenden Erfindung bezeichnet der Begriff "Lage" den Bereich einer Schicht bestehend aus einem Material.
Im Rahmen der vorliegenden Erfindung besteht eine "Doppellage" aus zwei Lagen aus unterschiedlichem Material.
Im Rahmen der vorliegenden Erfindung besteht eine "Schicht" aus einer oder mehreren Lagen oder Doppellagen.

Gegenstand der Erfindung ist demgemäß ein metastabiles, nanostabilisiertes Material, aufgebaut aus mehreren Doppellagen (A,B), beide in kubisch flächenzentrierter Gitterstruktur, wobei die Lage A die allgemeine Formel (R,N) und die Lage B die allgemeine Formel (R,aÜM)N aufweist, wobei
- R: refraktäres Element, ausgewählt aus der Gruppe bestehend aus Ti, Ta, Hf, V, Nb, Zr, Cr und Mischungen davon, vorzugsweise TiTa, TiZr, TiHf, ZrTa, ZrHf, TaHf,
- ÜM: Übergangsmetalle, ausgewählt aus der Gruppe bestehend aus Fe, Co und Mischungen davon, vorzugsweise FₑxCo_{y}, mit 0<x<1 und 0<y<1,
- N: Stickstoff,
a = 1, 2, wobei a für die Anzahl unterschiedlicher ÜM steht.

Die Herstellung des Materials erfolgt in der Weise, dass als Lage (A) ein Material auf einen Träger aufgebracht wird, das, für sich allein, in Form eines kubisch flächenzentrierten Gitters wächst und als Lage (B) ein Material auf einen Träger aufgebracht wird, das, für sich alleine, als kubisch raumzentriertes Gitter wächst.

Für die Lage (A) wird vorzugsweise TiN verwendet. Alternativ können auch TaN, HfN, VN, NbN, ZrN, CrN verwendet werden. Als Lage (B) kommt vorzugsweise FeCo in Betracht. Alternativ können auch Fe, Co verwendet werden.

Das erfindungsgemäße Material kann mittels der Dünnschicht-Technologie hergestellt werden, insbesondere Bedampfen, Sputtern (Kathodenzerstäubung) und lonenplattierung und Laserablation, sowie reaktive Varianten der Verfahren. Als Dünnschichtkonzept werden nanoskalige Viellagen-Schichten mit bis zu 1000 Einzellagen eingesetzt.

Für die Abscheidung von Mehr- oder Viellagenschichten werden die zu beschichtenden Substrate beispielsweise durch Verfahren von Position A* unter oder vor dem Target A zu Position B* unter oder vor dem Target B bewegt und wieder zurück. Auf jeder Position verbleiben die Substarte solange, bis die beabsichtigte Schichtdicke erreicht ist.
Ausgehend von vorzugsweise einem TiN-Target und einem vorzugsweise FeCo-Target lassen sich mittels Magnetronkathodenzerstäubung (PVD-Verfahren = Physical vapour deposition; physikalische Gasphasenabscheidung) ViellagenSchichten aus TiN und FeCo mit steigender Gesamtlagenzahl bei sinkender Einzellagendicke auf Silizium und Hartmetallsubstraten abscheiden.

Bei einer Doppellagendicke von 1,5 nm bis 10 nm, vorzugsweise <6 n bildet sich überraschend ein Mischkristall in kubisch flächenzentrierter Gitterstruktur. Hierin sind Fe und Co in hoher Konzentration eingelagert.

Diese Größenordnung ist für die Verwendung der erfindungsgemäßen Materialien als fernabfragbare Sensoranwendung bzw. fernabfragbarer Sensor besonders geeignet.

Die Schichten weisen bei über 2.000 HV0,05 eine hohe mechanische Härte und keine Härtereduktion durch Fe, Co-Gehalte auf. Die Schichten besitzen eine magnetische Permeabilität bis zu ca. 200 bei Grenzfrequenzen bis 1 Ghz (Der Zusammenhang zwischen der magnetischen Induktion B und der magnetischen Feldstärke H ist beschrieben über die materialabhängige Permeabilität µ. B = µ*H)

Durch das erfindungsgemäße Verfahren entsteht ein neues, metastabiles, nanostabilisiertes Material mit sowohl ausgezeichneten mechanischen als auch ferromagnetischen Eigenschaften. Das erfindungsgemäße Material ist temperaturfest und neigt nicht zur Entmischung. Die Temperaturfestigkeit besteht bis mindestens 600°C.

Erfindungsgemäß ist demgemäß ein neues Material zur Verfügung gestellt worden, welches aus (Ti,Fe,Co)N in kubisch flächenzentrierter Gitterstruktur besteht. Es sind mindestens zwei Lagen vorhanden. Bevorzugt sind Viellagen-Schichten im SandwichAufbau ABAB.... Die Verhältnisse der Lagendicken einer Doppellage TiN:FeCo liegen bei 0.5:1 bis 100:0.3, vorzugsweise 3:1.

Die Einzellagendicken (Schichten der Einzellagen) für FeCo liegen zwischen 0,3 nm und 5 nm, bevorzugt zwischen 0,4 nm und1 nm, insbesondere bei 0,6 nm. Durch die jeweils benachbarte FCC-TiN-Phase kommt es zu der Nanostabilisierung der (Ti,Fe,Co)N-Phasen. Die Eigenschaften bleiben bis 600°C unverändert.

Durch die Ausbildung der (Ti,Fe,Co)N Phase in kubisch flächenzentrierter Gitterstruktur wachsen beide Lagentypen in Viellagensystemen heteroepitaktisch aufeinander auf und bilden Kristallite mit einer Größe höher als die Einzellagendicke aus.

Neben dem dargestellten System TiN/FeCo können auch andere Systeme bzw. andere Materialklassen in Betracht kommen. Im Ergebnis wird die Gleichgewichtsstruktur von FeCo, welches normalerweise kubisch raumzentriert ist (quasi-BCC-Struktur), durch die Verwendung von Fe, Co, vorzugsweise in Viellagen-Schichten, gemeinsam mit TiN als neue (Ti,Fe,Co)N-Phase in einer kubisch flächenzentrierten Gitterstruktur nanostabilisiert.

Dieses neue Material weist gegenüber den Einzelmaterialien geänderte ferromagnetische Eigenschaften auf. Es besitzt sowohl ausgezeichnete ferromagnetische Hochfrequenzeigenschaften, als auch hervorragende mechanische Eigenschaften. Mithin wird ein verschleißfestes Material mit ferromagnetischen Hochfrequenzeigenschaften für Sensoranwendungen zur Verfügung gestellt.

Durch die Kombination von Hartstoffeigenschaften mit magnetischen Eigenschaften ist das erfindungsgemäße Material insbesondere für kombinierte Sensor- und Schutzschichtanwendugen im Verschleißbereich geeignet.
Ein daraus hergestellter Sensor kann dann je nach Aufbau auch berührungslos abgefragt werden. Durch entsprechende Kalibrierung ist es möglich, das sich ändernde Sensorvolumen bei Verschleißanwendungen, die Sensortemperatur oder den Spannungszustand zu beschreiben.

Das erfindungsgemäße Material kann allgemein in der Sensorelektronik und für Schutzschichten für allgemeinen Maschinen- und Automobilbau verwendet werden.

Ferner kann das erfindungsgemäße Material als Schutzschicht mit integriertem Verschleiß-, Temperatur- und/oder Spannungssensor, mit berührungsloser Auslesung, als ferromagnetische Verschleißschutzschicht, in Anwendungen für online Lebensdauer-Überwachung und zur Überprüfung der Integrität und Funktionsdauer von Maschinenelementen in intelligenten Produktionsprozessen verwendet werden.

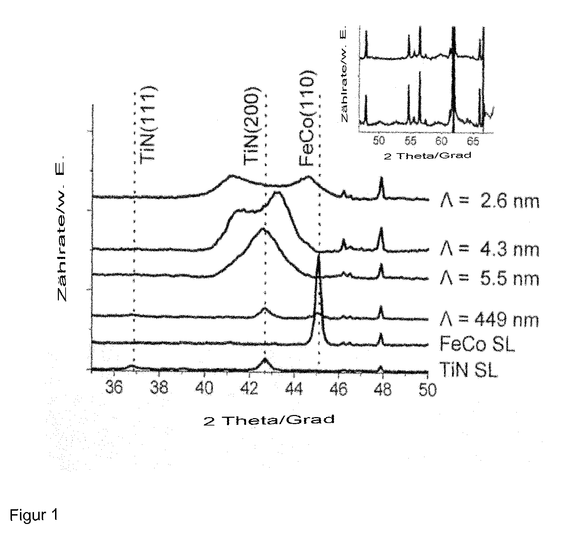

Im Folgenden wird die Erfindung unter Bezugnahme auf Figur 1 näher erläutert:
Mehrlagenschichten wurden in einer Leybold Z550 Laboranlage unter Einsatz eines FeCo- und eines TiN-Targets abgeschieden, beide mit einer nominalen Reinheit von 99,9% und einem Durchmesser von 150 mm. SiO₂ (1 µm)/Si Substrate (10x10 mm² Oberfläche, 375 µm Dicke) wurden 50 mm unterhalb der Mitte des Targets auf einer drehbaren Platte platziert und während des gesamten Prozesses in einem potentialfreien Zustand gehalten. Diese Platte (Probenteller) kann sich im Rahmen der vorliegenden Erfindung während des Beschichtungsprozesses auf Erdpotential, potentialfrei oder auf geringem Spannungspotential (Biasspannung 0 V>U>-50 V) befinden. Vor allen Abscheidungen wurde der Basisdruck in der Kammer auf p_{b}<1 x 10⁻⁶ mbar reduziert. Nach der Reinigung beider Targets und der Substrate, wurde das Schicht-Abscheideverfahren in reiner Argonatmosphäre bei 0.2 x 10⁻² mbar Gasdruck durchgeführt: Das FeCo Target wurde mit 250 W HF-Energie (= Hochfrequenzenergie 13,56 Mhz) betrieben, während das TiN Target mit 700 W DC-Energie (= Gleichspannung) betrieben wurde. Startend vor dem TiN-Target, wurden die Substrate zwischen beiden Targets bewegt, für eine Zeit angehalten und unter das andere Target bewegt. Die Haltezeit unter jedem Target war gleich, so dass das Verhältnis der Dicke der individuellen Lage unter Heranziehung der jeweiligen Abscheidungsraten (D_{TIN} ∼ 0.93 nms⁻¹, D_{Feco} ∼ 0.33nms⁻¹, bestimmt durch Kontakt-Profilometrie) ermittelt wurde. Die Haltezeit wurde von 807 Sekunden auf 0 Sekunden reduziert (letztere korrespondierend zur Rotation des Substrat-Tisches), während die Zahl der Doppellagen von n = 1 bis n = 390 erhöht wurde, um Mehrlagenschichten mit einer nominalen Gesamtdicke von 1 µm wachsen zu lassen.

Nach der Deposition wurden alle Mehrlagenschichten für 60 Minuten in einem Vakuum (p <1 x 10-⁸ mbar) bei 600°C in einem statischen Magnetfeld (µ₀Hₑₓₜ = 50 mT) ausgeglüht, um eine magnetische uniaxiale Anisotropie in der Ebene zu induzieren.

Für die Mehrlagenschichten wurde eine Röntgenbeugung in Bragg-Brentano-Geometrie (XRD) vor und nach dem Ausglühen durchgeführt. Für diese Messungen wurde Cu Kₐₗₚₕₐ-Strahlung eingesetzt.

Querschnitte der Schicht mit der niedrigsten Doppelalgendicke wurden für die TEM-Analyse, sowohl in dem abgeschiedenen Zustand als auch nach dem Ausglühen hergestellt. Diese wurden durch fokussiertes lonenstrahlätzen (FIB-Cutting) präpariert.

In Figur 1 werden Röntgenbeugungsdiagramme von Mehrlagenschichten mit 2,6 nm, 4,3 nm, 5,5 nm sowie 449 nm gezeigt. Zum Vergleich werden Röntgenbeugungsdiagramme von TiN und FeCo-Einlagenschichten mit einer Dicke von 1 µm, gewachsen bei denselben Voraussetzungen, als Bezug gezeigt. Das Röntgenbeugungsdiagramm der Schicht mit 449 nm zeigt die typischen (111) und (200) Beugungslinien von TiN in der NaCl-Kristallstruktur wie auch die (110) Reflektion von FeCo in der quasi-BCC-Struktur, welche die thermodynamisch stabilen Phasen des jeweiligen binären Materials bei Standardbedingungen (Druck = 1000 mbar;T = 20°C) darstellen. Mit der Abnahme der Doppellagendicke können bei den Röntgenbeugungsdiagramm mehrere Änderungen beobachtet werden: Die Verringerung der Doppellagendicke unterhalb von 449 nm führt zum Verschwinden der FeCo(110)-Reflektion, was die Abnahme in dem Kornwachstum anzeigt. In dem Röntgenbeugungsdiagramm der Mehrlagenschichten mit 4,3 nm und darunter spaltet sich der TiN(200)-Peak in eine Doppel-Peak-Struktur auf.

Eine Wärmebehandlung führte zu einem Kornwachstum in den individuellen TiN und FeCo Schichten in den Mehrlagenschichten mit Doppellagendicke >5,5 nm, wie mit Hilfe von Röntgenbeugungsuntersuchungen gezeigt werden konnte. In den Schichten mit einer Doppellagendicke <5,5 nm ist das "Aufspalten des Peaks" immer vorhanden, jedoch werden die Linienlagen bezüglich ihrer vorherigen Position verschoben.

## Patentansprüche

1. Metastabiles, nanostabilisiertes Material, aufgebaut aus mehreren Lagen (A,B), beide in kubisch flächenzentrierter Gitterstruktur, wobei die Lage A die allgemeine Formel (R,N) und die Lage B die allgemeine Formel (R,aÜM)N aufweist, wobei
R refraktäres Element, ausgewählt aus der Gruppe bestehend aus Ti, Ta, Hf, V, Nb, Zr, Cr und Mischungen davon,
ÜM Übergangsmetalle, aus gewählt aus der Gruppe bestehend aus Fe, Co und Mischungen davon,
N Stickstoff,
a = 1, 2, wobei a für die Anzahl unterschiedlicher ÜM steht.

2. Material nach Anspruch 1 **dadurch gekennzeichnet, dass** die Schichten auf metallisches, halbleitendes, keramisches oder Polymersubstrat abgeschieden werden.

3. Material nach Anspruch 1 **dadurch gekennzeichnet, dass** die Schichten in einer Sandwichstruktur ABAB... aufgebaut sind.

4. Material nach Anspruch 1 **dadurch gekennzeichnet, dass** die Dicke der Einzellagen für FeCo zwischen 0,3 nm und 2 nm, vorzugsweise bei 0,6 nm, und für TiN zwischen 1 nm und 100 nm, vorzugsweise bei 2,0 nm, liegt.

5. Material nach Anspruch 1 **dadurch gekennzeichnet, dass** die Gesamtschichtdicke zwischen 50 nm und 5 µm liegt.

6. Material nach Anspruch 1 **dadurch gekennzeichnet, dass** die Verhältnisse der Lagendicken einer Doppellage TiN:FeCo zwischen 100:0.3 und 0.5:1, vorzugsweise bei 3:1, liegen.

7. Material nach Anspruch 1 **dadurch gekennzeichnet, dass** es als kubischflächenzentrierte (Fe,Co,Ti)N/TiN Mehrlagenschicht vorliegt.

8. Verfahren zur Herstellung des Materials nach einem der Ansprüche 1 bis 7 **dadurch gekennzeichnet, dass** als Lage (A) ein Material, welches, für sich alleine, in Form eines kubisch flächenzentrierten Gitters wächst, und als Lage (B) ein Material, welches, für sich alleine, als kubisch raumzentriertes Gitter wächst, auf einen Träger aufgebracht wird.

9. Verfahren nach Anspruch 8 **dadurch gekennzeichnet, dass** metallisches, halbleitendes, keramisches oder Polymersubstrat als Träger verwendet werden.

10. Verfahren nach Anspruch 8 oder 9 **dadurch gekennzeichnet, dass** die Schichten mittels PVD-Verfahren, bevorzugt Magnetonkathodenzerstäubung, abgeschieden werden.

11. Verfahren nach einem der Ansprüche 8 bis 10 **dadurch gekennzeichnet, dass** für die Lage (A) TiN und für die Lage (B) FeCo eingesetzt wird.

12. Verwendung des Materials nach einem der Ansprüche 1 bis 8 oder des nach einem der Ansprüche 8 bis 11 hergestellten Materials als verschleißfestes Material für Sensoranwendungen.

13. Verwendung nach Anspruch 12, für kombinierte Sensor- und Schutzschichtanwendungen im Verschleißbereich.

14. Verwendung des Materials nach einem der Ansprüche 1 bis 8 oder des nach einem der Ansprüche 8 bis 11 hergestellten Materials für fernabfragbare Sensoranwendungen oder als fernabfragbare Sensoren.
